Europäisches Patentamt

European Patent Office

Office européen des brevets

(19)

(11) Numéro de publication: **0 289 402 B1**

(12) **FASCICULE DE BREVET EUROPEEN**

(45) Date de publication de fascicule du brevet: **11.11.92**

(51) Int. Cl.5: **C09D 1/00**, B05D 1/00, B29C 59/14, C08J 7/00

(21) Numéro de dépôt: **88400974.7**

(22) Date de dépôt: **21.04.88**

(54) **Revêtement protecteur du type SiCxNyOzHt obtenu par traitement avec un plasma.**

(30) Priorité: **22.04.87 FR 8705669**

(43) Date de publication de la demande:
**02.11.88 Bulletin 88/44**

(45) Mention de la délivrance du brevet:
**11.11.92 Bulletin 92/46**

(84) Etats contractants désignés:
**BE CH DE ES FR GB IT LI LU NL SE**

(56) Documents cités:
**EP-A- 0 110 258**
**GB-A- 2 071 673**
**US-A- 4 546 008**
**US-A- 4 645 684**

**JOURNAL OF APPLIED PHYSICS, vol. 55, no. 10, 15 mai 1984, pages 3785-3793, American Institute of Physics; R.C. ROSS et al.: "Plasma polymerization and deposition of amorphous hydrogenated silicon from rf and dc silane plasmas"**

(73) Titulaire: **L'AIR LIOUIDE, SOCIETE ANONYME POUR L'ETUDE ET L'EXPLOITATION DES PROCEDES GEORGES CLAUDE**
**75, Ouai d'Orsay**
**F-75321 Paris Cédex 07(FR)**

(72) Inventeur: **Bonet, Claude**
**36, rue Patenotre**
**F-78120 Rambouillet(FR)**
Inventeur: **Coeuret, François**
**63, bd Beethoven Résidence Les Sympho-nies**
**F-78280 Guyancourt(FR)**
Inventeur: **Nowak, Sylvie**
**7, rue Claude Debussy**
**F-78330 Fontenay-le-Fleury(FR)**
Inventeur: **Gauthier, Jean-Marie**
**39, rue Galliéni**
**F-91120 Palaiseau(FR)**

(74) Mandataire: **Le Moenner, Gabriel et al**
**Societé l'Air Liquide Chef du Service Bre-vets et Marques 75, Ouai d'Orsay**
**F-75321 Paris Cédex 07(FR)**

**Description**

La présente invention concerne le dépôt par plasma de revêtements protecteurs sur des substrats polymères transparents, en particulier pour la protection mécanique et anti-statique de vitrages, écrans ou supports optiques.

Dans l'industrie automobile, il est particulièrement intéressant de pouvoir remplacer le verre, notamment pour les glaces des optiques de phares, par des composés polymériques moins lourds et plus adaptés aux formes allongées et arrondies des accessoires automobiles. Il est cependant nécessaire de protéger ces composés polymériques contre les agressions chimiques et mécaniques par un revêtement transparent et de résistance mécanique et thermique convenable. Le document WO-A-85/04601 décrit la réalisation d'un tel revêtement en deux étapes, c'est-à-dire revêtement du substrat à protéger par trempage dans une résine silicone, puis polymérisation à chaud du revêtement.

La demanderesse a mis en évidence qu'il est possible de réaliser, suivant une technique simple, peu onéreuse et aisément modulable, des dépôts sur de tels substrats de films inorganiques homogènes, transparents, présentant une bonne tenue mécanique, antistatiques, et résistants aux variations thermiques et à l'humidité.

A cet effet, l'invention a pour objet un procédé de protection d'un substrat en matériau polymère transparent ayant une température de transition vitreuse par dépôt d'un film transparent inorganique, comportant, outre du silicium, au moins l'un des éléments carbone, azote, hydrogène et oxygène, comprenant les étapes d'exposer dans une enceinte la surface du substrat, à une température inférieure à la température de transition vitreuse du matériau du substrat, à un jet de plasma en présence d'un gaz précurseur du silicium et d'au moins un gaz précurseur d'un des dits éléments.

Le dépôt par plasma sur des substrats métalliques de composés comprenant du silicium est connu, en particulier dans le domaine de la micro-électronique, ou pour la réalisation de cellules photovoltaiques. De telles techniques sont décrites dans les documents US-A-4 546 008, US-A-4 645 684 et Journal of Applied Physics, vol. 55, n° 10, p. 3785-3793.

Le document EP-A-110 258 décrit un procédé d'application, sur du PVC semi-rigide ou flexible, avant métallisation, d'une sous-couche par dépôt plasma à partir d'un organosilane gazeux comprenant un halogène ou un groupe alkoxy, les exemples se référant à des chlorosilanes.

Selon une caractéristique plus particulière de l'invention, le substrat est un polymère présentant des bonnes propriétés de transparence optique et de tenue mécanique, du groupe comprenant les composés polyméthylméthacrylate, polystyrène-acrylonitrile, polystyrène cristal, polyimide, polyamide, polyester, et en particulier polycarbonate, le film déposé ayant alors typiquement pour composition $SiC_xN_yO_zH_t$ où x est compris entre 0 et 5 , y est compris entre 0 et 0,8 , z est compris entre 0 et 2,5 et t est compris entre 0 et 1,2.

La présente invention concerne également les substrats polymères transparents obtenus par ce procédé et l'application de ce dernier à la protection des vitrages, écrans ou supports optiques.

Le plasma gazeux peut, selon l'invention, être généré par tout moyen connu et en particulier par une source d'excitation radio-fréquence ou micro-onde, par exemple.

Le gaz au sein duquel est créé le plasma est un gaz plasmagène classique, tel que par exemple, les gaz rares de l'air, par exemple l'argon ou l'hélium ou encore le néon, ou l'hydrogène et leurs mélanges.

Cependant, il est également possible selon l'invention de créer le plasma avec un des gaz précurseurs des dits éléments, par exemple avec l'azote, l'ammoniac ou l'oxygène.

Par gaz précurseur d'un desdits éléments, on comprend selon l'invention un gaz comportant cet élément et capable de le libérer au sein du plasma. Les différents éléments libérés par les différents précurseurs se recombinent pour former le dépôt inorganique. Les éléments proviennent alors de sources annexes.

On peut choisir le gaz précurseur d'oxygène et/ou d'azote, en particulier parmi $O_2$, $N_2O$, $N_2$ et $NH_3$ et comme précurseur de carbone du méthane ou de l'éthane ou du $CO_2$. Le précurseur peut être utilisé seul comme gaz plasmagène, et ainsi dans certains cas l'utilisation de gaz plasmagène classique n'est pas nécessaire.

Les précurseurs du silicium sont avantageusement des "silanes", c'est-à-dire outre le silane $SiH_4$, les polysilanes tels que $Si_2H_6$ et $Si_3H_8$.

Ainsi, et comme on le verra dans les exemples, pour déposer de la sicile, on utilisera $SiH_4$, $O_2$ et le gaz plasmagène ; et pour un dépôt de nitrure de silicium, on utilisera, outre le gaz plasmagène, par exemple $N_2$ et $SiH_4$.

Enfin, on peut envisager de déposer des composés du silicium, du carbone, de l'azote, de l'oxygène selon l'invention à partir de silanes et de précurseur(s) d'oxygène, d'azote ou de carbone.

Mais pour réaliser un revêtement selon l'invention, l'apport en élément précurseur gazeux peut être d'un autre type, les éléments précurseurs pouvant provenir du substrat lui-même. En effet, les substrats polymériques génèrent eux-mêmes sous l'effet du plasma certains éléments constitutifs du revêtement. Il n'est plus alors nécessaire d'introduire sous forme gazeuse que le complément nécessaire à l'obtention des revêtements selon l'invention, par les sources annexes.

La demanderesse a mis en évidence que le ou les précurseurs de silicium sont avantageusement injectés en post-décharge, c'est-à-dire à l'extrémité aval, à faible énergie, de la zone visible du jet de plasma.

De plus, il peut être utile, avant d'effectuer le dépôt, de préparer la surface du substrat polymérique en réalisant un pré-traitement sous plasma, comme cela apparaîtra dans les exemples ce pré-traitement nettoie la surface du substrat et favorise l'adhésion du dépôt. En particulier, les prétraitements à l'oxygène et à l'ammoniac se sont révélés efficaces pour favoriser l'adhésion au revêtement.

De même, la demanderesse a mis en évidence qu'un post-traitement par plasma peut être avantageux pour la qualité et l'adhérence du dépôt, de même qu'un post-traitement thermique.

Le procédé par plasma micro-onde selon l'invention est mis en oeuvre à basse pression, c'est-à-dire de préférence à moins de 10 torr, et par exemple à une pression de l'ordre de moins de 0,5 torr (1 torr = $1,33.10^2$ Pa). Cette pression est adaptée selon le dispositif de génération du plasma mis en oeuvre.

Les températures à la surface du substrat lors de la mise en oeuvre du procédé selon l'invention, dans le cas du plasma micro-onde basse pression, par exemple sont de l'ordre de moins de 100°C, et en particulier inférieures aux températures de dégradation de la surface à traiter, en particulier inférieures à la température de transition vitreuse du substrat quand celui-ci est polymérique ; ceci présente l'avantage que l'on peut traiter des matériaux polymériques sans moyens de refroidissement durant la mise en oeuvre du procédé.

Ce procédé à basse température garantit en particulier les propriétés ultérieures des substrats protégés.

Les films déposés sont des polymères inorganiques et amorphes. Ils sont transparents et macroscopiquement continus, et d'une épaisseur de l'ordre du dizième de micromètre à quelques micromètres. Pour un substrat du type polycarbonate, dont la dureté selon l'échelle de Moh est de 2, celle du verre étant comprise entre 5 et 7, le film déposé selon l'invention lui confère une dureté de l'ordre de celle du verre. Leur dureté est donc dans ce cas supérieure à celle du substrat.

Les revêtements sont adhérents au substrat (test du papier adhésif) et résistants à l'abrasion. Les exemples ci-après décrivent les variations de température ainsi que les cycles thermiques que peuvent supporter les substrats revêtus.

La demanderesse a mis en évidence que la présence de carbone dans le revêtement entraîne une bonne résistance de celui-ci aux variations thermiques. Lorsque l'apport en carbone est réalisé par une source annexe, par exemple $CH_4$, le rapport Si/C provenant de cette source annexe est de préférence supérieur ou égal à 1.

Ces films ont en outre des propriétés de mouillabilité à l'eau supérieure à celles du substrat.

Outre ces propriétés, la demanderesse a mis en évidence que les revêtements selon l'invention ont des propriétés antistatiques.

De par leur dureté, ils présentent des avantages certains sur les dépôts organiques utilisés jusqu'alors pour la protection de supports d'informations tels que les disques laser et autres supports optiques ou magnétiques.

Etant transparents, ces dépôts peuvent être utilisés pour la protection superficielle de toutes pièces transparentes particulièrement sensibles aux poussières et autres éléments retenus en surface par des charges électrostatiques.

Pour l'obtention de telles propriétés antistatiques, d'adhérence et de dureté et de résistances aux cycles thermiques, les dépôts pour lesquels x = 0,3 - 1 ; y = 0,5 - 0,8 ; z = 1,3 - 2 et t = 0,6 - 1 sont particulièrement intéressants.

Le procédé selon l'invention assure une bonne qualité de la liaison surface-film dans des conditions normales ou agressives : adhérence, résistance aux bains chimiques, et.... Grâce aux propriétés optiques, mécaniques et chimiques de la couche déposée (adhérence, dureté, résistance à l'abrasion, résistance chimique, etc...), le revêtement déposé selon l'invention constitue une protection efficace des supports lors des agressions mécaniques ou chimiques, en particulier en ce qui concerne le maintien des qualités optiques (transmission élevée et diffusion faible).

Les substrats polymériques à protéger selon l'invention sont choisis particulièrement parmi les matériaux polymériques transparents moulés ou formés utilisés notamment comme glace dans les optiques de phares de véhicules. Il peut s'agir de matériaux du type polycarbonate en particulier, de polyméthylmétha-

EP 0 289 402 B1

crylate, de polystyrène acrylonitrile ou de polystyrène cristal.

Les polycarbonates sont des polymères par exemple du type poly- (oxycarbonyloxy-1, 4-phénylène isopropylidène-1, 4-phénylène) ou des copolymères à base de bisphénol A ou d'un comonomère.

D'autres substrats peuvent cependant être protégés par un revêtement dur antistatique selon l'invention. On peut citer en particulier les polyamides, le PVC, les polyesters tel le polyéthylènethéréphthalate, les polyimides.

Les matériaux transparents peuvent être utilisés pour les vitrages et écrans, c'est-à-dire, outre pour les glaces de phare ou lentilles, notamment pour les visières de casque de moto, les carénages de moto, les vitres fixes ou mobiles, latérales ou toits ouvrants de véhicules et hublots d'avion, les optiques d'éclairage urbain et domestique, les vitrages de sécurité, les écrans et protections pour appareils et tableaux indicateurs, les serres, vérandas et toitures en plastique, les verres organiques de montre ou de lunettes, ou les disques à lecture optique, à titre d'exemples non limitatifs.

C'est pourquoi la présente invention concerne également l'application des revêtements selon l'invention à la protection des vitrages et écrans et pour la protection contre les charges électrostatiques des supports d'informations.

L'invention sera mieux comprise au vu de la figure unique, à la lecture de la description détaillée, et des exemples de réalisation ci-après.

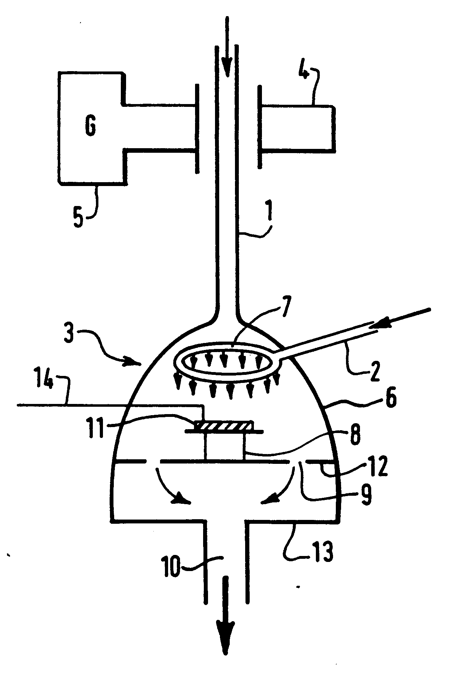

La figure 1 représente une coupe schématisée d'un mode de réalisation d'un dispositif pour la mise en oeuvre du procédé ci-dessus. L'enceinte **3** étanche est constituée d'une cloche **6** reposant sur une base circulaire **13**. Une première voie d'injection **1** (voie 1), de même axe que la cloche **6** est reliée à au moins une source de gaz, non représentée. Cette voie d'injection **1** traverse un guide d'onde **4** relié à un générateur de micro-ondes **5**. Une seconde voie d'injection **2** (voie 2) relie à au moins une source de gaz, non représentée, traverse de façon étanche la paroi de la cloche **6** et est munie à son extrémité intérieure à la cloche **6** d'un répartiteur **7** du flux gazeux, de forme torique et muni d'orifices régulièrement espacés.

Le substrat **11** est placé sur un support **8** ; le support **8** comporte un plateau-support **12** muni d'orifices **9** symétriquement répartis. La base circulaire **13** de la cloche **6** comporte un orifice **10** d'évacuation des effluents de même axe que la cloche et relié à joint étanche à des moyens pour créer une dépression dans l'enceinte, non représentés. Il peut s'agir d'une pompe à vide par exemple. Un thermocouple **14** mesure la température à la surface de l'échantillon **11** et traverse la cloche à joint étanche.

La structure décrite ci-dessus permet de mettre en oeuvre le procédé de la façon suivante :

Comme cela apparaîtra dans les exemples, par la voie **1** pénètre un gaz plasmagène, qui reçoit l'énergie micro-onde du générateur G UHF par l'intermédiaire du guide d'ondes **4**. Des gaz précurseurs peuvent également être injectés par cette voie **1**. La voie **2** et son répartiteur **7** permettent d'injecter le gaz précurseur du silicium, et éventuellement de l'hélium ou de l'argon.

Cependant la voie **2** peut également permettre l'injection de gaz plasmagène lorsque la voie **1** n'est empruntée que par un gaz précurseur. De préférence, le précurseur de silicium est injecté en post décharge par la voie **2**.

La disposition axiale de la voie d'injection **1** et le répartiteur **7** de la voie d'injection **2** sont des moyens pour réaliser une injection homogène des gaz. De même, l'orifice **10**, également axial et les orifices **9** du plateau **12** répartis symétriquement contribuent à l'homogénéïté de l'évacuation des gaz. L'écoulement homogène de gaz conditionne l'homogénéïté du dépôt sur le substrat **11** placé au centre des flux ainsi créés.

D'autres variants non représentées, par exemple où la symétrie ne serait pas cylindrique, ou encore où les voies d'injection seraient multipliées, sont également envisageables, leur disposition devant tenir compte de la forme, de la taille et du nombre des substrats à traiter, dans le soucis d'une homogénéïté des flux gazeux, qui détermine l'homogénéïté du dépôt.

Les moyens de dépressions non représentés à l'extérieur du dispositif, à l'extrémité de l'orifice **10** permettent de réguler la pression en fonction des débits gazeux.

On peut selon l'invention utiliser à la place du guide d'onde d'autres moyens connus pour créer un plasma micro-onde, ou pour créer un autre type de plasma.

Ainsi, dans une autre variante non représentée, on utilise pour exciter la colonne de gaz d'autres moyens de création du plasma, par exemple un inducteur entourant la voie d'injection et alimenté en courant radio-fréquence.

**Exemple 1** : Dépôt d'oxyde de silicium

Les conditions du dépôt dans un dispositif tel que décrit à la figure **1** sont les suivantes :
G = Générateur micro-onde 2,45 GHz

4

Pression = $0,5.10^2$ Pa.

Débit total = 5 l/h (les % sont relatifs au débit total)

P désigne la puissance transmise par le plasma, t le temps de traitement,

$\theta$ la température en surface du polycarbonate.

Les gaz employés sont présentés au tableau I suivant :

## TABLEAU I

| PRE-TRAITEMENT | | | DEPOT | | | |
|---|---|---|---|---|---|---|
| GAZ | P(W) | t(mn) | GAZ | P(W) | t(mn) | θ(°C) |
| Ar <br> + <br> Ar + 10% $O_2$ | 200 <br> 200 | 1 <br> 1 | Voie 1: 89% Ar + 10% $O_2$ <br> Voie 2: 1% $SiH_4$ | 50 | 30 | 89 |
| Ar <br> + <br> Ar + 10% $O_2$ | 200 <br> 300 | 1 <br> 1 | Voie 1: 10% $O_2$ <br> Voie 2: 89% Ar + 1% $SiH_4$ | 300 | 60 | 47 |
| Ar <br> + <br> He + 60% $O_2$ | 200 <br> 400 | 1 <br> 1 | Voie 1: 10 % $O_2$ <br> Voie 2: 89% Ar + 1% $SiH_4$ | 300 | 30 | 46 |

**Exemple 2** : Dépôt d'oxynitrure de silicium

Les dépôts ont été effectués dans les mêmes conditions générales et pour les conditions particulières données au tableau II annexé. Les échantillons de substrat traités font 5 x 5 cm et sont en polycarbonate commercialisé par General Electric sous le nom de LEXAN et Bayer sous le nom de MAKROLON.

Les dépôts d'oxynitrure de silicium à partir de $N_2$ obtenus comme décrit ci-dessus sont transparents et adhérents et ont été testés :
- Adhérence : bonne (test du ruban adhésif)
- Transparence (contrôle visuel) : excellente
- Homogénéité (analyse X induite par électron) : excellente
- Spectres IR (Bandes principales) : SiN (autour de 900 cm$^{-1}$)
  Si-NH (3335 cm$^{-1}$;1170 cm$^{-1}$)
  SiO (1000-1100 cm$^{-1}$)
- tenue à l'eau distillé : 72 h à 60°C. Aucune altération du revêtement du premier échantillon. L'adhérence reste bonne.
- Epaisseur : 1 à 5 $\mu$m suivant la durée de dépôt
- Densité : non mésurée, vraisemblablement peu dense
- Résistance à l'abrasion = les 7 échantillons ont été testés du point de vue de la transmission et de la diffusion de la lumière, avant et après le test d'abrasion par le sable par la méthode dite du sabot. Dans les dernières colonnes du tableau apparaissent les moyennes de variation des échantillons en transmission (T) et diffusion (D).

Les échantillons avant et après abrasion doivent présenter des variations de moins de 10 % en transmission et de moins de 4 % en diffusion pour convenir selon ce test. Les échantillons préparés répondent très bien à ces exigences.

TABLEAU II

| PRE-TRAITEMENT | | | DEPOT | | | | POST-TRAITEMENT | | | TEST ABRASION | |
|---|---|---|---|---|---|---|---|---|---|---|---|
| GAZ | P(W) | t(mn) | GAZ | P(W) | t(mn) | Ø(°C) | GAZ | P(W) | t(mn) | T% | D% |
| Ar | 200 | 1,5 | Voie 1:29% Ar + 10% N$_2$ / Voie 2:60% He + 1% SiH$_4$ | 80 | 60 | 81 | - | | | 3,3 | 1,6 |
| Ar / Ar + 10% N$_2$ | 200 / 200 | 1,5 / 1,5 | Voie 1:29% Ar + 10% N$_2$ / Voie 2:60% He + 1% SiH$_4$ | 80 | 60 | 78 | - | | | 1,0 | 2,0 |
| Ar / Ar + 10% NH | 200 / 300 | 1,5 / 1,5 | Voie 1:29% Ar + 10% N$_2$ / Voie 2:60% He + 1% SiH$_4$ | 80 | 60 | 83 | - | | | 1 | 2,4 |
| Ar / Ar + 10% NH$_3$ | 200 / 300 | 1,5 / 1,5 | Voie 1:29% Ar + 10% N$_2$ / Voie 2:60% He + 1% SiH$_4$ | 80 | 120 | 80 | - | | | 0,3 | 0,2 |
| Ar | 200 | 1,5 | Voie 1:29% Ar + 10% N$_2$ / Voie 2:60% He + 1% SiH$_4$ | 80 | 60 | 80 | Ar | 50 | 10 | 0,3 | 1,3 |
| Ar | 200 | 1,5 | Voie 1:29% Ar + 10% N$_2$ / Voie 2:60% He + 1% SiH$_4$ | 80 | 120 | 90 | Ar | 50 | 30 | 2,9 | 0,9 |
| Ar | 200 | 1,5 | Voie 1:89% Ar + 10% N$_2$ / Voie 2:1% SiH$_4$ | 80 | 60 | 92 | - | | | 2,9 | 1,7 |

**Exemple 3** :

Un dépôt est réalisé selon le procédé sur un échantillon de polycarbonate de 5 x 2 cm selon la séquence suivante :

1) prétraitement plasma Ar puis plasma Ar contenant 10 % de NH$_3$,

6

2) dépôt par plasma pendant 1 h d'une couche d'épaisseur 0,9 $\mu$m et de composition Si $C_{0,5}$ $N_{0,8}$ $O_2$H à partir d'une phase gazeuse de composition : $SiH_4$ = 0,6 % ; Ar = 69 % ; He = 20,4 % ; $N_2$ = 10 %.

On a utilisé un générateur à micro-onde G à 2,45 GHz ; la puissance transmise par le plasma est de 60 à 80W.

La pression est de $0,15.10^2$ Pa.

L'échantillon ainsi revêtu est alors introduit dans un enceinte thermique maintenue à + 25°C pour y subir un cyclage thermique tel que défini ci-dessous.

- 16h à + 25°C
- descente de + 25°C à - 25°C à 0,6°C/min.
- 1h à - 25°C
- chauffage de - 25°C à + 80°C à 1°C/min.
- 1h à + 80°C
- retour à + 25°C.

L'échantillon subit 10 cycles consécutifs sans aucune altération.

### Exemple 3 bis :

Ce même échantillon placé 17h dans une atmosphère contenant 100 % d'HR (humidité relative) à + 25°C ne subit aucune altération.

### Exemple 4 :

Cet exemple met en évidence le rôle du carbone sur les propriétés mécaniques et sur la tenue à l'environment des dépôts sur polycarbonate.

Un échantillon de polycarbonate de 5 x 2 cm est recouvert d'un dépôt réalise dans les mêmes conditions que l'exemple 3, à une pression de $0,5.10^2$ Pa, selon la séquence suivante :

1) prétraitement plasma Ar puis plasma Ar contenant 10 % de $NH_3$,
2) dépôt par plasma pendant 1h d'une couche d'épaisseur 1,7 $\mu$m à partir d'une phase gazeuse de composition :

$SiH_4$ = 0,6 % ; $CH_4$ = 0,6 % ; $N_2$ = 10 % ; He = 20,4 % ; Ar = 68,4 %.

Cet échantillon très adhérent subit avec succès 8 cycles thermiques (tels que définis à l'exemple 3) consécutifs. Aucune altération n'est observée après 24h à 25°C et 100 % HR.

### Revendications

1. Procédé de protection d'un substrat en matériau polymère transparent ayant une température de transition vitreuse, par dépôt, sur le substrat, d'un film transparent inorganique comportant du silicium et au moins l'un des éléments carbone, azote, hydrogène et oxygène, caractérisé en ce que le film de protection est obtenu en exposant dans une enceinte la surface du substrat, à une température inférieure à la température de transition vitreuse du matériau du substrat, à un jet de plasma en présence d'un gaz précurseur du silicium et d'au moins un gaz précurseur d'un desdits éléments.

2. Procédé selon la revendication 1, caractérisé en ce que le substrat est un polymère transparent du groupe comprenant les composés polycarbonate, polyméthylméthacrylate, polystyrène-acrylonitrile, polystyrène cristal, polyimide, polyester, polyamide.

3. Procédé selon la revendication 1 ou 2, caractérisé en ce que le gaz précurseur du silicium est un silane.

4. Procédé selon la revendication 3, caractérisé en ce que le gaz précurseur du silicium est introduit dans une région de faible énergie du jet de plasma.

5. Procédé selon la revendication 4, caractérisé en ce que la température de la surface exposée du substrat est inférieure à 100°C.

6. Procédé selon l'une des revendications précédentes, caractérisé en ce que le gaz précurseur d'un desdits éléments est choisi parmi $O_2$ $N_2O$, $N_2$, $NH_3$, $CH_4$, $CO_2$ et $C_2H_4$.

**7.** Procédé selon la revendication 6, caractérisé en ce que le film déposé a pour composition $SiC_xN_yO_zH_t$, où $x$ est compris entre 0 et 5, $y$ est compris entre 0,3 et 0,8, $z$ est compris entre 1,3 et 2,5, et $t$ est compris entre 0,5 et 1,2.

**8.** Procédé selon l'une des revendications précédentes, caractérisé en ce qu'il comporte l'étape préalable d'effectuer un prétraitement par plasma de la surface du substrat avant dépôt du film de protection.

**9.** Procédé selon la revendication 8, caractérisé en ce que le prétraitement par plasma est effectué en présence d'oxygène.

**10.** Procédé selon l'une des revendications précédentes, caractérisé en ce qu'il comporte l'étape ultérieure d'effectuer un post-traitement thermique ou par plasma du dépôt déposé sur la surface du substrat.

**11.** Substrat polymère transparent revêtu d'un dépôt protecteur obtenu par le procédé selon l'une des revendications précédentes.

**12.** Application du procédé selon l'une des revendications 1 à 10 à la protection de vitrages, écrans ou supports optiques.

## Claims

**1.** Process for the protection of a substrate made of a transparent polymer material having a vitreous transition temperature, by depositing on the substrate an inorganic transparent film comprising silicon and at least one element from among carbon, nitrogen, hydrogen and oxygen, characterised in that the protective film is obtained by exposing within an enclosure the surface of the substrate, at a temperature lower than the vitreous transition temperature of the material of the substrate, to a jet of plasma in the presence of a silicon precursor gas and at least one precursor gas of one of the said elements.

**2.** Process according to claim 1, characterised in that the substrate is a transparent polymer of the group comprising polycarbonate, polymethylmethacrylate, polystyrene-acrylonitrile, crystal polystyrene, polyimide, polyester and polyamide compounds.

**3.** Process according to claim 1 or 2, characterised in that the silicon precursor gas is a silane.

**4.** Process according to claim 3, characterised in that the silicon precursor gas is introduced in a region of low power of the plasma jet.

**5.** Process according to claim 4, characterised in that the temperature of the exposed surface of the substrate is less than 100°C.

**6.** Process according to one of the preceding claims, characterised in that the precursor gas of one of the said elements is chosen from among $O_2$, $N_2O$, $N_2$, $NH_3$, $CH_4$, $CO_2$ and $C_2H_4$.

**7.** Process according to claim 6, characterised in that the deposited film has the composition $SiC_xN_yO_zH_t$, in which $x$ is between 0 and 5, $y$ is between 0.3 and 0 8 $z$ is between 1.3 and 2.5, and $t$ is between 0.5 and 1.2.

**8.** Process according to one of the preceding claims, characterised in that it comprises the preliminary step of carrying out a pretreatment by plasma of the surface of the substrate before the protective film is deposited.

**9.** Process according to claim 8, characterised in that the pretreatment by plasma is carried out in the presence of oxygen.

**10.** Process according to one of the preceding claims, characterised in that it comprises the subsequent step of carrying out a thermal post-treatment or a post-treatment by plasma of the deposit deposited on the surface of the substrate.

**11.** Transparent polymer substrate coated with a protective deposit obtained by the process according to one of the preceding claims.

**12.** Application of the process according to one of claims 1 to 10 to the protection of glazing, screens or optical bases.

**Patentansprüche**

**1.** Verfahren zum Schutz eines transparenten Polymermaterialsubstrates mit einer Glasübergangstemperatur durch Ablagerung eines anorganischen transparenten Filmes, der Silicium und wenigstens eines der Elemente Kohlenstoff, Stickstoff, Wasserstoff und Sauerstoff umfaßt, auf dem Substrat, **dadurch gekennzeichnet,** daß der Schutzfilm erhalten wird, indem man die Substratoberfläche in einem umschlossenen Raum einer Temperatur unterhalb der Glasübergangstemperatur des Substratmaterials und einem Plasmastrahl in Gegenwart eines Silciumvorläufergases und wenigstens eines Vorläufergases eines der besagten Elemente aussetzt.

**2.** Verfahren nach Anspruch 1, **dadurch gekennzeichnet,** daß das Substrat ein transparentes Polymer der Gruppe ist, die die Verbindungen Polycarbonat, Polymethylmethacrylat, Polystyrol-Acrylnitril, kristallkiares Polystyrol, Polyimid, Polyester und Polyamid umfaßt.

**3.** Verfahren nach Anspruch 1 oder 2, **dadurch gekennzeichnet,** daß das Siliciumvorläufergas ein Silan ist.

**4.** Verfahren nach Anspruch 3, **dadurch gekennzeichnet,** daß das Siliciumvorläufergas in einen Bereich geringer Energie des Plasmastrahles eingeführt wird.

**5.** Verfahren nach Anspruch 4, **dadurch gekennzeichnet,** daß die Temperatur der dem Plasmastrahl ausgesetzten Substratoberfläche unter 100 °C ist.

**6.** Verfahren nach einem der vorausgehenden Ansprüche, **dadurch gekennzeichnet,** daß das Vorläufergas eines der besagten Elemente unter $O_2$, $N_2O$, $N_2$, $NH_3$, $CH_4$, $CO_2$ und $C_2H_4$ ausgewählt wird.

**7.** Verfahren nach Anspruch 6, **dadurch gekennzeichnet,** daß der abgelagerte Film die Zusammensetzung $SiC_xN_yO_zH_t$ hat, worin x zwischen 0 und 5 liegt, y zwischen 0,3 und 0,8 liegt, z zwischen 1,3 und 2,5 liegt und t zwischen 0,5 und 1,2 liegt.

**8.** Verfahren nach einem der vorausgehenden Ansprüche, **dadurch gekennzeichnet,** daß es die Vorstufe einer Vorbehandlung der Substratoberfläche durch Plasma vor der Schutzfilmablagerung umfaßt.

**9.** Verfahren nach Anspruch 8, **dadurch gekennzeichnet,** daß die Vorbehandlung durch Plasma in Gegenwart von Sauerstoff erfolgt.

**10.** Verfahren nach einem der vorausgehenden Ansprüche, **dadurch gekennzeichnet,** daß es die nachträgliche Stufe einer thermischen Nachbehandlung der auf der Substratoberfläche aufgebrachten Ablagerung oder eine Nachbehandlung derselben durch Plasma umfaßt.

**11.** Transparentes Polymersubstrat, beschichtet mit einer Schutzablagerung, die nach dem Verfahren nach einem der vorausgehenden Ansprüche erhalten wurde.

**12.** Anwendung des Verfahrens nach einem der Ansprüche 1 bis 10 zum Schutz von Gläsern, Blendschirmen oder optischen Trägern.